# EUROPEAN PATENT APPLICATION

(11) **EP 4 563 992 A1**
(43) Date of publication of application: **04.06.2025**
(21) Application number: 23846093.5
(22) Date of filing: 26.06.2023
(51) Int. Cl.: G01N 27/04, G01N 27/06, G01R 27/02, G01R 27/22

(54) **IMPURITY DETECTION SUPPORT DEVICE, IMPURITY DETECTION SUPPORT METHOD, AND TEST LIQUID PROCESSING SYSTEM**

(30) Priority: 29.07.2022 JP 2022121302; 31.01.2023 JP 2023013081
(71) Applicant: Panasonic Intellectual Property Management Co., Ltd., Kadoma-shi, Osaka 571-0057 (JP)
(72) Inventor: NAKAI Miyuki, Kadoma-shi, Osaka 571-0057 (JP); KUME Toshiro, Kadoma-shi, Osaka 571-0057 (JP)
(74) Representative: Novagraaf International SA
(86) International application number: PCT/JP2023/023565
(87) International publication number: WO 2024/024359

(57) **Abstract**

An impurity detection support device 100 comprises: a pipeline 102 through which a test liquid flows; a pair of electrodes disposed so as to be capable of applying an alternating-current voltage to, or capable of superimposing an alternating current onto the test liquid between a first position and a second position in the pipeline 102; a power source unit 106 for applying the alternating-current voltage, having a frequency fixed to a predetermined usage frequency, or superimposing the alternating current, having a frequency fixed to the usage frequency, between the pair of electrodes; a measuring unit 108 for measuring a current or a voltage generated between the pair of electrodes; and a calculating unit 110 for calculating a resistance of the test liquid using a measurement result from the measuring unit 108. The usage frequency is determined on the basis of the resistance of the test liquid measured by an alternating current impedance method, or a resistance of a reference liquid that does not include any impurities.

## Description

### TECHNICAL FIELD

The present disclosure relates to an impurity detection support device, an impurity detection support method, and a system for processing a liquid under test.

### BACKGROUND ART

When a solid-liquid mixture having electronic conductivity is produced, conductive particles such as metal particles may be mixed as impurities. When a solid-liquid mixture is used in an electronic device, impurities may cause failure of the electronic device. Examples of the electronic device include a power storage device such as a lithium ion battery, a lithium ion secondary battery, an alkaline dry battery, an electric double layer capacitor, and an electrochemical capacitor. Examples of the solid-liquid mixture include an electrode slurry used in these power storage devices. When conductive impurities are mixed in the electrode slurry, the conductive impurities can cause a short circuit between the positive and negative electrodes, etc. In this background, Patent literature 1, for example, discloses a method for magnetically detecting a metal foreign substance contained in an aqueous slurry containing an electrode active material and a particulate binder.

### RELATED-ART LITERATURE

### PATENT LITERATURE

[Patent literature 1] WO2014/142045

### SUMMARY OF INVENTION

### TECHNICAL PROBLEM

The related-art method for detecting conductive impurities by using magnetism has not been able to detect conductive impurities comprised of non-magnetic materials. Therefore, the related-art method has an insufficient rate of detection of conductive impurities. It is also desired to increase the rate of detection of insulating impurities comprised of non-magnetic materials for the purpose of reducing failure in electronic devices.

The present disclosure addresses the issue described above, and a purpose thereof is to provide a technique for increasing the rate of detection of impurities in a liquid under test.

### SOLUTION TO PROBLEM

1. An embodiment of the present disclosure relates to an impurity detection support device. The device includes: a pipe in which a liquid under test flows; a first electrode and a second electrode provided in the pipe, the first electrode and the second electrode being arranged such that an AC voltage is adapted to be applied to or an AC current is adapted to be superimposed on the liquid under test in a space extending between a first position of the pipe and a second position shifted from the first position in a direction of extension of the pipe; a power supply unit that applies an AC voltage with a frequency fixed at a predetermined operating frequency or superimposes an AC current with a frequency fixed at the operating frequency between the first electrode and the second electrode; a measurement unit that measures a current generated between the first electrode and the second electrode due to application of the AC voltage or measures a voltage generated between the first electrode and the second electrode due to superposition of the AC current; and a calculation unit that calculates a resistance of the liquid under test using a measurement result of the measurement unit, the resistance being an indicator for determining whether the liquid under test contains impurities. The operating frequency is determined based on a resistance of the liquid under test or a resistance of a reference solution not containing impurities measured by AC impedance method.

Another embodiment of the present disclosure relates to an impurity detection support method. The method includes: measuring a resistance of a liquid under test or a resistance of a reference solution not containing impurities by AC impedance method to determine an operating frequency based on the resistance measured; causing the liquid under test to flow in a pipe; applying an AC voltage with a frequency fixed at the operating frequency to or superimposing an AC current with a frequency fixed at the operating frequency on the liquid under test in a space extending between a first position of the pipe and a second position shifted from the first position in a direction of extension of the pipe; measuring a current generated due to application of the AC voltage or measuring a voltage generated due to superposition of the AC current; and calculating a resistance of the liquid under test using a measurement result, the resistance being an indicator for determining whether the liquid under test contains impurities.

2. An embodiment of the present disclosure relates to an impurity detection support device. The device includes: a pipe in which a liquid under test flows; a first electrode and a second electrode provided in the pipe, the first electrode and the second electrode being arranged such that an AC voltage is adapted to be applied to or an AC current is adapted to be superimposed on the liquid under test in a space extending between a first position of the pipe and a second position shifted from the first position in a direction of extension of the pipe; a power supply unit that applies an AC voltage with a frequency fixed at a predetermined operating frequency or superimposes an AC current with a frequency fixed at the operating frequency between the first electrode and the second electrode; a measurement unit that measures a current generated between the first electrode and the second electrode due to application of the AC voltage or measures a voltage generated between the first electrode and the second electrode due to superposition of the AC current; and a calculation unit that calculates an amount of change in a resistance of the liquid under test per unit time using a measurement result of the measurement unit, the amount of change per unit time being an indicator for determining whether the liquid under test contains impurities. The operating frequency is determined based on a resistance of the liquid under test or a resistance of a reference solution not containing impurities measured by AC impedance method.

Another embodiment of the present disclosure relates to a system for processing a liquid under test including a plurality of the impurity detection support devices according to the above embodiment. The system includes, as the impurity detection support devices, a first impurity detection support device and a second impurity detection support device connected to each other by a pipe in which the liquid under test flows, and the system includes a filter provided between the first impurity detection support device and the second impurity detection support device in the pipe to collect impurities in the liquid under test.

Another embodiment of the present disclosure relates to a system for processing a liquid under test. The system includes: the impurity detection support device according to the above embodiment; a first tank that stores the liquid under test not determined to be free of impurities by the impurity detection support device; a second tank that stores the liquid under test determined to be free of impurities by the impurity detection support device; a first pipe connected to the first tank and the impurity detection support device, in which first pipe the liquid under test guided from the first tank to the impurity detection support device flows; a second pipe connected to the impurity detection support device and the first tank, in which second pipe the liquid under test guided from the impurity detection support device to the first tank flows; a third pipe connected to the impurity detection support device and the second tank, in which third pipe the liquid under test guided from the impurity detection support device to the second tank flows; a filter provided in the first pipe to collect impurities in the liquid under test; and a control device that switches a flow path of the liquid under test between the second pipe and the third pipe according to a determination result of the impurity detection support device.

Another embodiment of the present disclosure relates to an impurity detection support method. The method includes: measuring a resistance of a liquid under test or a resistance of a reference solution not containing impurities by AC impedance method to determine a predetermined operating frequency based on the resistance measured; causing the liquid under test to flow in a pipe; applying an AC voltage with a frequency fixed at the operating frequency to or superimposing an AC current with a frequency fixed at the operating frequency on the liquid under test in a space extending between a first position of the pipe and a second position shifted from the first position in a direction of extension of the pipe; measuring a current generated due to application of the AC voltage or measuring a voltage generated due to superposition of the AC current; and calculating an amount of change in a resistance of the liquid under test per unit time using a measurement result, the amount of change per unit time being an indicator for determining whether the liquid under test contains impurities.

Optional combinations of the aforementioned constituting elements, and implementations of the present disclosure in the form of methods, apparatuses, and systems may also be practiced as additional modes of the present disclosure.

### ADVANTAGEOUS EFFECTS OF INVENTION

According to the present disclosure, the rate of detection of impurities in a test liquid under test can be increased.

### BRIEF DESCRIPTION OF DRAWINGS

[Fig. 1] Fig. 1 is a schematic diagram of a coating device in which an impurity detection support device according to embodiment 1 and embodiment 2 is provided.
[Fig. 2] Fig. 2 is a schematic diagram of the electrode unit.
[Fig. 3] Fig. 3 is a diagram illustrating a method for setting the operating frequency.
[Fig. 4] Fig. 4 is a diagram showing the result of measurement of the resistance of the liquid under test.
[Fig. 5] Fig. 5 is a flowchart showing an example of the impurity detection support method according to embodiment 1.
[Fig. 6] Fig. 6 is a diagram showing a result of measuring the amount of change in the resistance of the liquid under test per unit time.
[Fig. 7] Fig. 7 is a flowchart showing an example of the impurity detection support method according to embodiment **2.**
[Fig. 8] Fig. 8 is a schematic diagram of the system for processing the liquid under test according to embodiment **3.**
[Fig. 9] Fig. 9 is a schematic diagram of the system for processing the liquid under test according to embodiment **4.**

### DESCRIPTION OF EMBODIMENTS

Hereinafter, the present disclosure will be described based on preferred embodiments with reference to the accompanying drawings. The embodiments are not intended to limit the scope of the present disclosure but exemplify the present disclosure. Not all of the features and the combinations thereof described in the embodiments are necessarily essential to the present disclosure. Identical or like constituting elements, members, processes shown in the drawings are represented by identical symbols and a duplicate description will be omitted as appropriate. The scales and shapes of the parts shown in the figures are defined for convenience's sake to make the explanation easy and shall not be interpreted limitatively unless otherwise specified. Terms like "first", "second", etc. used in the specification and claims do not indicate an order or importance by any means unless specified otherwise and are used to distinguish a certain feature from the others. Those of the members that are not material to the description of the embodiments are omitted in the drawings.

### (Embodiment 1)

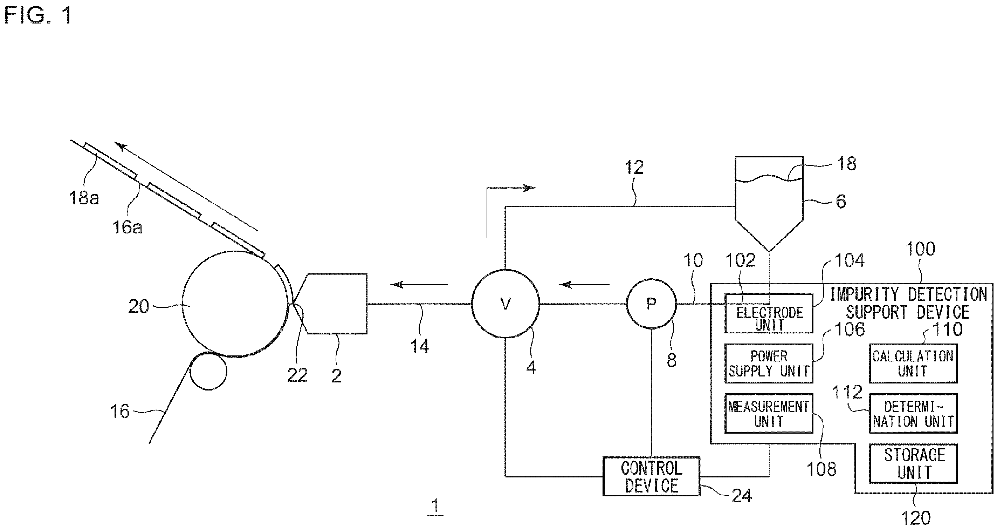

Fig. 1 is a schematic diagram of a coating device 1 in which an impurity detection support device 100 according to embodiment 1 is provided. Fig. 1 depicts some of the constituting elements of the respective devices as functional blocks. The functional blocks are implemented in hardware such as devices and circuits exemplified by a CPU and a memory of a computer, and in software such as a computer program. It will be understood by those skilled in the art that these functional blocks may be implemented in a variety of forms by combinations of hardware and software.

The coating device 1 includes a coating die 2, a valve 4, a tank 6, a pump 8, a feed pipe 10, a return pipe 12, and a die supply pipe 14.

The coating die 2 is an instrument for applying a paint 18 to a coated body 16. The coating device 1 of the present embodiment is used, by way of one example, to manufacture an electrode plate of a secondary battery. An electrode plate of a secondary battery is a sheet-shaped electrode material obtained by applying an electrode slurry to a current collector and drying the resultant product. In the present embodiment, therefore, the coated body 16 is a current collector of a secondary battery, and the paint 18 is an electrode slurry of a secondary battery. The current collector is, for example, a metal foil. The electrode slurry is an electronically conductive solid-liquid mixture containing a solvent and at least one of an electrode active material or a conductive additive. In the case of common lithium ion secondary batteries, the positive electrode plate is produced by coating an aluminum foil with an electrode slurry containing a positive electrode active material such as lithium cobalt oxide and lithium iron phosphate. The slurry for the positive electrode may contain a conductive additive such as graphite. Further, the negative electrode plate is produced by coating a copper foil with an electrode slurry containing a negative electrode active material (or conductive additive) such as graphite.

The coating die 2 is arranged such that a discharge port 22 faces the circumferential surface of a backup roll 20 at a predetermined interval. The coated body 16 is continuously transported by the rotation of the backup roll 20 to a position where the backup roll 20 and the discharge port 22 face each other.

A valve 4 is connected to the coating die 2 via the die supply pipe 14. The valve 4 can switch between supply and non-supply of the paint 18 to the coating die 2. The coating device 1 can discharge the paint 18 from the coating die 2 to the coated body 16 while the paint 18 is being supplied to the coating die 2. The tank 6 is connected to the valve 4 via the feed pipe 10 and the return pipe 12.

The tank 6 stores the paint 18. The feed pipe 10 is provided with the pump 8, and the pump 8 is driven to feed the paint 18 from the tank 6 to the valve 4. The valve 4 supplies the paint 18 supplied from the tank 6 to the coating die 2 via the die supply pipe 14. Alternatively, the valve 4 returns the paint 18 supplied from the tank 6 to the tank 6 via the return pipe 12.

As the valve 4 supplies the paint 18 to the coating die 2, the paint 18 can be discharged from the coating die 2 to form a coated portion 18a coated with the paint 18 on the coated body 16. Further, as the valve 4 returns the paint 18 to the tank 6, application of the paint 18 from the coating die 2 can be stopped and an uncoated portion 16a not coated with the paint 18 can be formed on the coated body 16. That is, the valve 4 can intermittently coat the paint 18 on the coated body 16. The uncoated portion 16a is used for pasting the center lead of the electrode, etc. The configuration of each part of the coating device 1 is not limited to the one described above.

The coating device 1 is provided with an impurity detection support device 100 according to the present embodiment. The impurity detection support device 100 includes a pipe 102, an electrode unit 104, a power supply unit 106, a measurement unit 108, a calculation unit 110, a determination unit 112, and a storage unit 120.

The pipe 102 is a flow path through which the liquid under test that is tested to determine whether it contains impurities flows. The impurities subject to detection support in this embodiment is impurities that change the resistance of the liquid under test. These impurities include conductive impurities that decrease the resistance of the liquid under test and insulating impurities that increase the resistance of the liquid under test. Conductive impurities comprise, for example, a metal. Insulating impurities comprise, for example, a bubble and an insulating substance. In the present embodiment, the region in the feed pipe 10 between the tank 6 and the pump 8 constitutes the pipe 102. That is, the impurity detection support device 100 is provided in the feed pipe 10. Further, the paint 18, in other words, the electrode slurry, represents the liquid under test.

The impurity detection support device 100 may be provided in the region in the feed pipe 10 between the pump 8 and the valve 4. Alternatively, the impurity detection support device 100 may be provided in the return pipe 12, the die supply pipe 14, or the like. The coating device 1 can also be interpreted as including a circulation device or a transport device for the paint 18 composed of the tank 6, the pump 8, the feed pipe 10, and the return pipe 12. In this case, the impurity detection support device 100 provided in the feed pipe 10 or the return pipe 12 can be interpreted as being provided in the circulation device or the transport device. Further, the coating device 1 is not limited to the manufacture of an electrode plate of a secondary battery, and the coated body 16 and the paint 18 may not be an electrode plate and an electrode slurry. Further, the impurity detection support device 100 may be provided in a device other than the coating device 1 and, for example, in a manufacturing device for manufacturing the liquid under test.

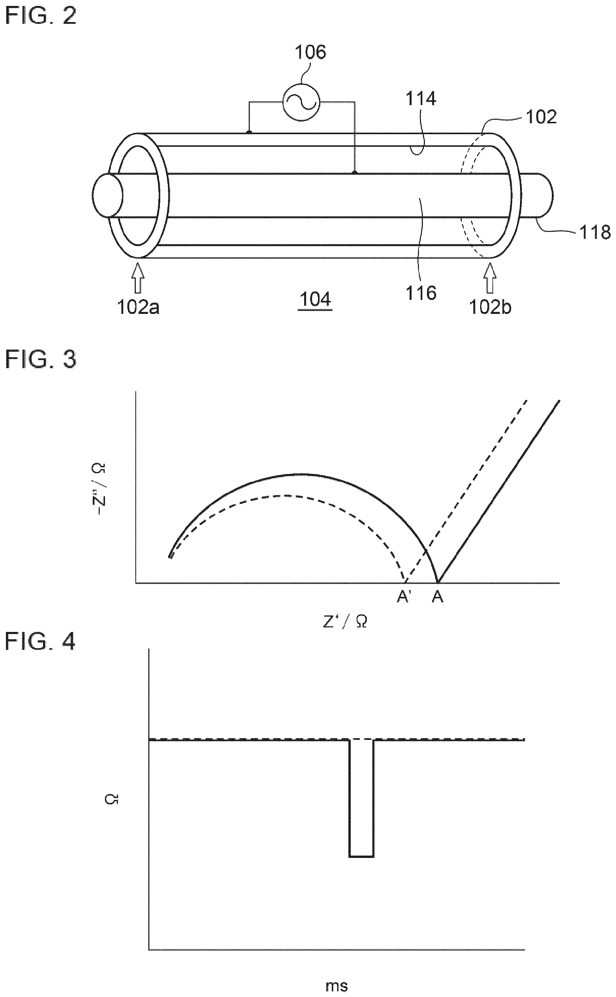

The electrode unit 104 includes a first electrode 114 and a second electrode 116. Hereinafter, the first electrode 114 and the second electrode 116 may be collectively referred to as a pair of electrodes for convenience. Fig. 2 is a schematic diagram of the electrode unit 104. A pair of electrodes is provided in the pipe 102. The electrode unit 104 according to one example has a rod-shaped body 118 that is inserted into the pipe 102 and arranged at an interval from the pipe 102. The first electrode 114 is provided in the pipe 102, and the second electrode 116 is provided in the rod-shaped body 118. The first electrode 114 and the second electrode 116 are insulated from each other. The first electrode 114 and the second electrode 116 are made of a material having electrical conductivity. The material has, for example, a volume resistivity of 0.1 Ω·cm or less. Specific examples of materials constituting the first electrode 114 and the second electrode 116 include insoluble metals such as stainless steel, titanium, platinum, gold, niobium, and ruthenium and include carbon. These materials can also be combined as appropriate.

The first electrode 114 is provided at least on the inner wall (inner circumferential surface) of the pipe 102. The first electrode 114 may be provided on the entire inner wall of the pipe 102 or in a part thereof. When the first electrode 114 is provided in a part of the inner wall, it may be provided in a partial region in the direction of flow of the liquid under test, or provided in a partial region in the circumferential direction of the pipe 102. Further, the entire pipe 102 may be made of an insoluble metal or the like, and the entire pipe 102 may constitute the first electrode 114. That is, the first electrode 114 may be provided only on the surface of the inner wall of the pipe 102 or may be provided inside the inner wall.

The second electrode 116 is provided at least on the outer wall (outer circumferential surface) of the rod-shaped body 118. The second electrode 116 may be provided on the entire outer wall of the rod-shaped body 118 or may be provided in a part thereof. When the second electrode 116 is provided in a part of the outer wall, it may be provided in a partial region in the direction of flow of the liquid under test, or provided in a partial region in the circumferential direction of the rod-shaped body 118. Further, the entire rod-shaped body 118 may be made of an insoluble metal or the like, and the entire rod-shaped body 118 may constitute the second electrode 116. That is, the second electrode 116 may be provided only on the surface of the outer wall of the rod-shaped body 118 or may be provided inside the outer wall.

The first electrode 114 and the second electrode 116 are arranged such that an AC voltage can be applied to or an AC current can be superimposed on the liquid under test in the space extending between an arbitrary first position 102a of the pipe 102 and a second position 102b shifted from the first position 102a in the direction of extension of the pipe 102. By way of one example, the first electrode 114 and the second electrode 116 have an elongated shape extending in the direction of extension of the pipe 102. Therefore, the pair of electrodes extend parallel to the axial center of the pipe 102, spaced apart in the radial direction of the pipe 102. Preferably, the pair of electrodes are arranged such that the distance between the pair of electrodes is equal at any position in the direction of extension of the pipe 102.

Thereby, an AC voltage can be applied to or an AC current can be superimposed on the liquid under test spreading in the direction of extension of the pipe 102 between the first position 102a and the second position 102b, and, in other words, in the direction of flow of the liquid under test. Thereby, the efficiency of detection of impurities can be increased. The distance between the first position 102a and the second position 102b, and, in other words, the length of the first electrode 114 and the second electrode 116 in the direction of extension of the pipe 102 is, for example, equal to or greater than the distance between the pair of electrodes, and, for example, the diameter of the pipe 102.

Further, the rod-shaped body 118 is arranged such that the distance to the inner wall of the pipe 102 is substantially equal at each position in the direction of extension of the pipe 102. That is, the rod-shaped body 118 has a uniform size at least from the first position 102a to the second position 102b and extends parallel to the axial center of the pipe 102. Thereby, the distance between the pair of electrodes (the radial distance of the pipe 102) can be made substantially equal in the direction of extension of the pipe 102. As a result, the accuracy of detection of impurities by the impurity detection support device 100 can be increased.

Further, the rod-shaped body 118 is arranged such that the distance to the inner wall of the pipe 102 is substantially equal at each position in the circumferential direction of the rod-shaped body 118. That is, the pipe 102 and the rod-shaped body 118 are arranged coaxially. Thereby, the distance between the pair of electrodes can be made substantially equal in the circumferential direction of the rod-shaped body 118. As a result, the accuracy of detection of impurities by the impurity detection support device 100 can be increased. Stated otherwise, the rod-shaped body 118 constituting the second electrode 116 extends, by being inserted into the center of the pipe 102, without being deviated in the radial direction of the pipe 102 and parallel to the direction of extension of the pipe 102 without tilting.

In the example shown in Fig. 2, the rod-shaped body 118 is a solid body. The rod-shaped body 118 may not be a solid body. For example, the rod-shaped body 118 may be a hollow body. In this case, the interior of the rod-shaped body 118 is sealed and does not allow the liquid under test to flow. By using a solid or hollow rod-shaped body 118, it is possible to suppress an increase in the pressure loss occurring due to the rod-shaped body 118 when the liquid under test passes through the pipe 102. The rod-shaped body 118 may be a tubular mesh. In this case, the liquid under test can flow in and out of the rod-shaped body 118 through the mesh opening while flowing in the pipe 102. By using the tubular mesh rod-shaped body 118, the contact area between the second electrode 116 and the liquid under test can be increased, and the accuracy of detection of impurities by the impurity detection support device 100 can be increased.

The pair of electrodes may have a filter shape and extend in a direction intersecting the direction of extension of the pipe 102 and, for example, in the radial direction of the pipe 102. For example, the first electrode 114 extends in the radial direction of the pipe 102 at the first position 102a. Further, the second electrode 116 extends in the radial direction of the pipe 102 at the second position 102b. The first electrode 114 and the second electrode 116 having a filter shape are, for example, fixed to the pipe 102. When the pipe 102 is made of a metal, insulation is provided between each electrode and the pipe 102. When the pipe 102 is non-metallic, insulation between each electrode and the pipe 102 can be omitted, and the electrode and the pipe 102 may be in direct contact with each other. The first electrode 114 and the second electrode 116 are comprised of, for example, mesh sheets, slit sheets, or porous sheets. The liquid under test flowing in the pipe 102 can travel downstream from each electrode through the mesh of each electrode. By configuring each electrode to have a filter shape, the contact area between each electrode and the liquid under test can be increased, and the accuracy of detection of impurities by the impurity detection support device 100 can be increased.

The power supply unit 106 applies an AC voltage or superimposes an AC current between the first electrode 114 and the second electrode 116. The power supply unit 106 can be configured by a known AC/DC converter, inverter, control circuit, or the like. For example, the first electrode 114 is connected to the negative electrode output terminal of the power supply unit 106, and the second electrode 116 is connected to the positive electrode output terminal of the power supply unit 106. Therefore, the first electrode 114 is the negative electrode, and the second electrode 116 is the positive electrode. The first electrode 114 may be the positive electrode, and the second electrode 116 may be the negative electrode. The control circuit is composed of, for example, a microcomputer and can control, according to a measurement result of the measurement unit 108, each switching element of the power supply unit 106 so that the current or the voltage maintains the target value.

The power supply unit 106 applies an AC voltage with a frequency fixed at a predetermined operating frequency between the pair of electrodes. Alternatively, the power supply unit 106 superimposes an AC current with a frequency fixed at a predetermined operating frequency between the pair of electrodes. The operating frequency is preset and maintained in the storage unit 120. Fig. 3 is a diagram illustrating a method for setting the operating frequency. In this embodiment, the operating frequency is determined based on the resistance of the liquid under test or the resistance of a reference solution not containing impurities measured by the AC impedance method. The reference liquid has the same composition as the liquid under test not containing impurities. That is, the reference liquid differs from the liquid under test only in that it is clear that impurities are not contained. "Not containing impurities" preferably means that the content of impurities is zero but may also encompass cases where impurities are contained in an amount less than the detection limit of the impurity detection support device 100.

Specifically, the resistance is measured according to the AC impedance method by applying an AC voltage to or superimposing an AC current on the liquid under test or the reference liquid while changing the frequency. As a result, the graph shown in Fig. 3 is obtained. In Fig. 3, the horizontal axis represents the real number of resistance, and the vertical axis represents the imaginary number of resistance. Further, the frequency decreases from the left side toward the right side of Fig. **3****.** The solid line represents the resistance of the reference liquid that does not contain impurities. The dashed line represents the resistance of the liquid under test containing conductive impurities. Regardless of the presence or absence of impurities, the resistance graph is arc-shaped on the highfrequency side and linear on the low-frequency side. Further, as the frequency is gradually lowered, the graph switches from an arc to a straight line with a predetermined frequency as an inflection point. When conductive impurities are contained, approximately the entire graph shifts in the direction that the resistance is lowered as compared to the case where impurities are not contained. When the liquid under test contains insulating impurities, approximately the entire graph shifts in the direction that the resistance is increased as compared to the case where impurities are not contained, although an illustration thereof is omitted.

In the graph obtained, the frequency at the inflection point is defined as a reference frequency A. Then, an arbitrary frequency included in a range A×10⁻¹ to A×10 is defined as the operating frequency. As shown in Fig. 3, the reference frequency A is shifted to the low resistance side (the reference frequency A') when conductive impurities are contained in the liquid under test. By defining the frequency included in the range A×10⁻¹ to A×10 as the operating frequency, it is possible to detect a change in resistance due to contamination by conductive impurities in the liquid under test more reliably than otherwise. Even when insulating impurities are contained in the liquid under test, a change in resistance caused by insulating impurities can be detected more reliably than otherwise by defining the operating frequency as described above. When the liquid under test is an electrode slurry, the operating frequency is included in, for example, a range 100 Hz to 10 kHz.

When the reference liquid is used for resistance measurement by the AC impedance method, the frequency at the inflection point detected by measuring the resistance once can be defined as the reference frequency **A.** When the liquid under test is used for resistance measurement, multiple inflection points are preferably detected by measuring the resistance multiple times, and the average value of frequencies at the inflection points is defined as the reference frequency **A.** By measuring the resistance multiple times, the number of inflection points detected when impurities have not passed between the pair of electrodes can be increased. This ensures that the reference frequency A acquired using the liquid under test is close to the reference frequency A acquired using the reference liquid.

Further, a reference resistance is set. The reference resistance is the original resistance of the liquid under test, **i.e.,** the resistance of the reference liquid. When the reference liquid is used for resistance measurement by the AC impedance method, for example, the resistance at the inflection point detected by measuring the resistance once can be defined as the reference resistance. When the liquid under test is used for resistance measurement, multiple inflection points are preferably detected by measuring the resistance multiple times, and the average value of resistance at the inflection points is defined as the reference resistance. By measuring the resistance multiple times, the number of inflection points detected when impurities have not passed between the pair of electrodes can be increased. This ensures that the reference resistance is close to the original resistance of the liquid under test.

When the reference liquid is used to set the operating frequency and the reference resistance, the setting process is easy, and the accurate operating frequency and reference resistance can be set. When the liquid under test is used for the setting process, the cost and labor required for the setting process can be reduced because preparation of the reference liquid is not required. Further, when the setting process is performed in the impurity detection support device 100, the labor of replacing the reference liquid with the liquid under test can be omitted in a migration from the setting process to impurity determination. The preset reference resistance is maintained in the storage unit 120.

Resistance measurement by the AC impedance method, acquisition of the reference frequency **A,** setting of the operating frequency and the reference resistance and input thereof to the storage unit 120 are performed in advance in a preparatory step before the impurity detection process performed by the impurity detection support device 100. The preparatory step may be performed using the impurity detection support device 100 or may be performed using another device.

The measurement unit 108 measures the current generated between the first electrode 114 and the second electrode 116 due to the application of the AC voltage fixed at the operating frequency. Alternatively, the measurement unit 108 measures the voltage generated between the first electrode 114 and the second electrode 116 due to the superposition of the AC current fixed at the operating frequency. For measurement of the current generated between the pair of electrodes, the measurement unit 108 can be configured by a known ammeter, FRA (Frequency Response Analyzer), or the like electrically connected to the pair of electrodes. For measurement of the voltage generated between the pair of electrodes, the measurement unit 108 can be configured by a known voltmeter, FRA, or the like electrically connected to the pair of electrodes.

The calculation unit 110 calculates the resistance of the liquid under test by using the measurement result of the measurement unit 108. When the power supply unit 106 applies the AC voltage between the pair of electrodes, the current generated between the pair of electrodes via the liquid under test is measured by the measurement unit 108. In this case, the calculation unit 110 can calculate the resistance component of the liquid under test from the value of this current and the value of the AC voltage applied between the pair of electrodes. The magnitude of the applied AC voltage can be appropriately selected according to the electrode area, the distance between the electrodes, the type of the liquid under test, and the like, and is preferably 1 to 100 mV, and, more preferably 5 to 50 mV. The application time of the AC voltage is not particularly limited. The AC voltage may be biased.

Further, when the power supply unit 106 superimposes the AC current between the pair of electrodes, the voltage generated between the pair of electrodes via the liquid under test is measured by the measurement unit 108. In this case, the calculation unit 110 can calculate the resistance component of the liquid under test from the value of this voltage and the value of the AC current superimposed between the pair of electrodes. The magnitude of the AC current superimposed can be appropriately selected according to the electrode area, the distance between the electrodes, the type of the liquid under test, and the like, and is preferably 5 nA to 5 A, and, more preferably, 50 nA to 500 mA. The superposition time of the AC current is not particularly limited. The AC current may be biased.

Fig. 4 is a diagram showing the result of measurement of the resistance of the liquid under test. In Fig. 4, the horizontal axis represents time and the vertical axis represents resistance. The solid line represents the resistance of the liquid under test. The dashed line represents the reference resistance. When the liquid under test is not contaminated by impurities, the resistance of the liquid under test is equal to the reference resistance. When conductive impurities are mixed in the liquid under test, on the other hand, the resistance of the liquid under test decreases as shown in Fig. 4 as conductive impurities pass between the first electrode 114 and the second electrode 116. When insulating impurities pass between the first electrode 114 and the second electrode 116, the resistance of the liquid under test increases, although an illustration thereof is omitted. This change in resistance occurs whether the impurities are magnetic or non-magnetic. Therefore, the resistance of the liquid under test is an indicator for determining whether the liquid under test contains impurities. Therefore, it is possible to detect contamination by impurities by capturing a change in the resistance of the liquid under test flowing in the pipe 102.

The determination unit 112 determines whether the liquid under test contains impurities according to the resistance calculated by the calculation unit 110. For example, the determination unit 112 compares the resistance calculated by the calculation unit 110 with the reference resistance maintained in the storage unit 120. Then, the determination unit 112 determines that the liquid under test contains impurities when the difference between the calculated resistance and the reference resistance exceeds a predetermined threshold. The threshold can be set appropriately based on an experiment, simulation, etc. by the designer. When the liquid under test is an electrode slurry, the threshold value is set to, for example, a value 2 to 3% the reference resistance. Since the impurity detection support device 100 includes the determination unit 112, the user can grasp contamination by impurities more quickly than otherwise.

As an example, the determination result of the determination unit 112 is sent to the control device 24. The control device 24 may display the determination result of the determination unit 112 on a monitor (not shown). Further, when it is determined by the determination unit 112 that the liquid under test contains impurities, the control device 24 may notify the user of the impurity detection support device 100 of the determination result by a known notification method. The notification method is not particularly limited, and a known method such as generating an alert sound or turning on an alert lamp can be employed. Thereby, the user can monitor the presence or absence of impurities in real time. In addition, the user can know contamination by impurities more promptly.

Further, the value of the voltage or the current measured by the measurement unit 108 may be sent to the control device 24. The control device 24 may display a waveform of a voltage value or a current value on an oscilloscope (not shown). Further, the value of the resistance calculated by the calculation unit 110 may be sent to the control device 24. The control device 24 may display the resistance value on a monitor. In this case, the user can determine the presence or absence of impurities from the resistance value displayed on the monitor. When the resistance value itself is used by the user, the determination unit 112 may be omitted.

As an example, the execution of the impurity detection process can be directed by the user via the control device 24 or by an operation program in the control device 24. The same applies to a change in the setting of the impurity detection process. Further, the control device 24 may control the valve 4 and the pump 8.

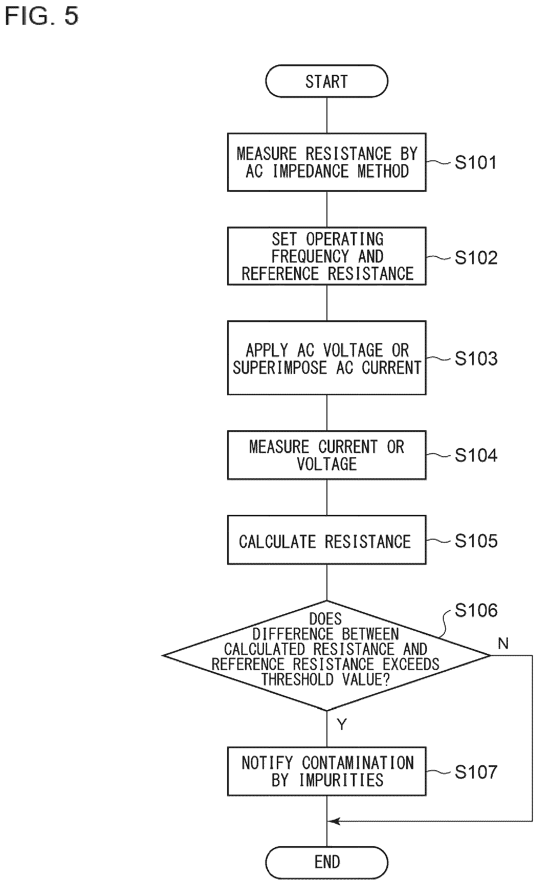

Fig. 5 is a flowchart showing an example of the impurity detection support method. This flow is repeatedly executed at, for example, a predetermined interval. First, the resistance of the liquid under test or the resistance of the reference liquid is measured by the AC impedance method (S101). Then, the operating frequency and the reference resistance are determined based on the resistance measured in step S101 (S102).

Subsequently, while the liquid under test is flowing through the pipe 102, an AC voltage with a frequency fixed at the operating frequency is applied or an AC current with a frequency fixed at the operating frequency is superimposed between the first electrode 114 and the second electrode 116 (S103). As a result, an AC voltage is applied to or an AC current is superimposed on the liquid under test in the space expanding between the first position 102a and the second position 102b. Then, the current generated between the first electrode 114 and the second electrode 116 due to the application of the AC voltage is measured, or the voltage generated between the first electrode 114 and the second electrode 116 due to the superposition of the AC current is measured (S104). Subsequently, the resistance of the liquid under test is calculated based on the measured current or voltage (S105). It is then determined whether the difference between the calculated resistance and the reference resistance exceeds a threshold value (S106).

When the difference between the calculated resistance and the reference resistance exceeds the threshold value (Y in S106), the user is notified that the liquid under test contains impurities (S107), and the routine ends. When the difference between the calculated resistance and the reference resistance is equal to or less than the threshold value (N in S106), the user is not notified, and the routine ends.

As described above, the impurity detection support device 100 according to this embodiment measures the resistance that serves as an indicator for determining the presence or absence of impurities by applying an AC voltage to or superimposing an AC current on the liquid under test. Therefore, a highly reliable determination indicator can be obtained even if the impurities are non-magnetic. Accordingly, the rate of detection of impurities in the liquid under test can be increased. Further, the frequency of the AC voltage applied to or the AC current superimposed on the liquid under test is fixed at the operating frequency. For this reason, the time required for resistance measurement can be shortened. According to this embodiment, resistance measurement of the liquid under test can be performed on the order of, for example, several milliseconds.

Further, since an electric field is generated in the liquid under test flowing in the pipe 102, impurities can be detected while the liquid under test is being transported. In other words, an in-line impurity detection process can be realized. In addition, complete inspection of the liquid under test can be easily realized since a work such as sample collection is not required. Therefore, it is possible to suppress introduction of foreign matter into the subsequent process.

By way of example, the liquid under test is an electrode slurry containing a solvent and at least one of an electrode active material or a conductive additive. In this case, it is possible to suppress a short circuit between the positive and negative electrodes caused by impurities themselves by detecting impurities with high accuracy. If the positive electrode slurry contains impurities (particularly, metal impurities) in a power storage device in which an electrolytic solution is interposed between the positive and negative electrodes, impurities could elute in the electrolytic solution when the power storage device is charged, resulting in reduction and precipitation on the surface of the negative electrode. When this precipitation is repeated, impurities could grow in a dendrite shape, penetrate the separator, and reach the positive electrode, causing a short circuit. Therefore, it is also possible to suppress a short circuit caused by a dendrite, by increasing the rate of detection of impurities.

As an example, the pipe 102 is provided in the coating device 1 including the coating die 2 for applying the liquid under test to the coated body 16 and the tank 6 for storing the liquid under test. Alternatively, the pipe 102 is provided in a circulation device or a transport device for the liquid under test. Thereby, the impurity detection process can be performed in the process of transporting the liquid under test from the tank 6 to the coating die **2.** Further, the impurity detection process can be applied to the liquid under test until just before the liquid under test is applied to the coated body 16, by arranging the impurity detection support device 100 in the feed pipe 10 or the die supply pipe 14 of the coating device **1.** Thereby, the risk of foreign matter contamination in the electronic device can be further reduced, and the performance of the electronic device can be further improved.

Further, the impurity detection support device 100 can be mounted in an existing device simply by using a part of the pipe in the existing device as the pipe 102, or by replacing a part of the pipe by the pipe 102 of the impurity detection support device 100. Therefore, the installation, replacement, and maintenance of the impurity detection support device 100 are easy.

Embodiment 1 of the present invention is described above in detail. The embodiment described above is merely a specific example of practicing the present disclosure. The details of the embodiment shall not be construed as limiting the technical scope of the present disclosure. A number of design modifications such as modification, addition, deletion, etc. of constituting elements may be made to the extent that they do not depart from the idea of the present disclosure defined by the claims. New embodiments with design modifications will provide the combined advantages of the embodiment and the variation. Although the details subject to such design modification are emphasized in the embodiment by using phrases such as "of this embodiment" and "in this embodiment", details not referred to as such are also subject to design modification. Any combination of the above constituting elements is also useful as an embodiment of the present disclosure. Hatching in the cross section in the drawings should not be construed as limiting the material of the hatched object.

The invention according to embodiment 1 described above may be defined by the following items.

### [Item 1]

An impurity detection support device (100) including:
a pipe (102) in which a liquid under test flows;
a first electrode (114) and a second electrode (116) provided in the pipe (102), the first electrode (114) and the second electrode (116) being arranged such that an AC voltage is adapted to be applied to or an AC current is adapted to be superimposed on the liquid under test in a space extending between a first position (102a) of the pipe (102) and a second position (102b) shifted from the first position (102a) in a direction of extension of the pipe (102);
a power supply unit (106) that applies an AC voltage with a frequency fixed at a predetermined operating frequency or superimposes an AC current with a frequency fixed at the operating frequency between the first electrode (114) and the second electrode (116);
a measurement unit (108) that measures a current generated between the first electrode (114) and the second electrode (116) due to application of the AC voltage or measures a voltage generated between the first electrode (114) and the second electrode (116) due to superposition of the AC current; and
a calculation unit (110) that calculates a resistance of the liquid under test using a measurement result of the measurement unit (108), the resistance being an indicator for determining whether the liquid under test contains impurities,
wherein the operating frequency is determined based on a resistance of the liquid under test or a resistance of a reference solution not containing impurities measured by AC impedance method.

### [Item 2]

The impurity detection support device (100) according to Item **1,** including:
a determination unit (112) that determines whether the liquid under test contains impurities according to the resistance calculated by the calculation unit (110).

### [Item 3]

The impurity detection support device (100) according to Item 1 or Item **2,**
wherein the liquid under test is an electrode slurry containing a solvent and at least one of an electrode active material or a conductive additive.

### [Item 4]

The impurity detection support device (100) according to any one of Item 1 to Item **3,** wherein
the pipe (102) is provided in at least one of a coating device (1) that coats a coated body (16) with the liquid under test, a circulation device for the liquid under test, or a transport device for the liquid under test.

### [Item 5]

An impurity detection support method including:
measuring a resistance of a liquid under test or a resistance of a reference solution not containing impurities by AC impedance method to determine an operating frequency based on the resistance measured;
causing the liquid under test to flow in a pipe (102);
applying an AC voltage with a frequency fixed at the operating frequency to or superimposing an AC current with a frequency fixed at the operating frequency on the liquid under test in a space extending between a first position (102a) of the pipe (102) and a second position (102b) shifted from the first position (102a) in a direction of extension of the pipe (102);
measuring a current generated due to application of the AC voltage or measuring a voltage generated due to superposition of the AC current; and
calculating a resistance of the liquid under test using a measurement result, the resistance being an indicator for determining whether the liquid under test contains impurities.

### [Item 6]

The impurity detection support method according to Item 5, further including:
determining whether the liquid under test contains impurities according to the resistance calculated.

### (Embodiment 2)

Fig. 1 is a schematic diagram of a coating device 1 in which an impurity detection support device 100 according to embodiment 2 is provided.

The coating device 1 according to this embodiment has the same configuration as the coating device 1 according to embodiment 1. In other words, the coating device 1 includes a coating die 2, a valve 4, a tank 6, a pump 8, a feed pipe 10, a return pipe 12, and a die supply pipe 14. Since the structure of each part is the same as that of embodiment 1, a description thereof is omitted.

The coating device 1 is provided with the impurity detection support device 100 according to this embodiment. The impurity detection support device 100 includes a pipe 102, an electrode unit 104, a power supply unit 106, a measurement unit 108, a calculation unit 110, a determination unit 112, and a storage unit 120.

Since the pipe 102 is the same as the pipe 102 of embodiment 1, a description thereof is omitted.

Since the electrode unit 104 is the same as the electrode unit 104 of embodiment **1,** a description thereof is omitted.

Since the power supply unit 106 is the same as the power supply unit 106 of embodiment **1,** a description thereof is omitted.

Since the method for setting the operating frequency is the same as that of embodiment 1 except that the setting of the reference resistance is not performed, a description thereof is omitted

Since the measurement unit 108 is the same as the measurement unit 108 of embodiment **1,** a description thereof is omitted.

The calculation unit 110 calculates the amount of change in the resistance of the liquid under test per unit time by using the measurement result of the measurement unit 108. Hereinafter, the amount of change in the resistance per unit time is referred to as the rate of change in the resistance. When the power supply unit 106 applies the AC voltage between the pair of electrodes, the current generated between the pair of electrodes via the liquid under test is measured by the measurement unit 108. In this case, the calculation unit 110 can calculate the resistance component of the liquid under test from the value of this current and the value of the AC voltage applied between the pair of electrodes. Further, the rate of change in the resistance can be calculated by differentiating the resistance component obtained with respect to time. The magnitude of the applied AC voltage can be appropriately selected according to the electrode area, the distance between the electrodes, the type of the liquid under test, and the like, and is preferably 1 to 100 mV, and, more preferably 5 to 50 mV. The application time of the AC voltage is not particularly limited. The AC voltage may be biased.

Further, when the power supply unit 106 superimposes the AC current between the pair of electrodes, the voltage generated between the pair of electrodes via the liquid under test is measured by the measurement unit 108. In this case, the calculation unit 110 can calculate the resistance component of the liquid under test from the value of this voltage and the value of the AC current superimposed between the pair of electrodes. Further, the rate of change in the resistance can be calculated by differentiating the resistance component obtained with respect to time. The magnitude of the AC current superimposed can be appropriately selected according to the electrode area, the distance between the electrodes, the type of the liquid under test, and the like, and is preferably 5 nA to 5 A, and, more preferably, 50 nA to 500 mA. The superposition time of the AC current is not particularly limited. The AC current may be biased.

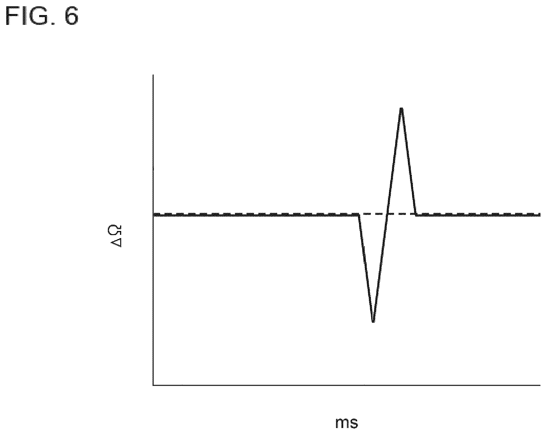

Fig. 6 is a diagram showing a result of measuring the amount of change in the resistance of the liquid under test per unit time. In Fig. **6****,** the horizontal axis represents time [ms], and the vertical axis represents the amount of change in the resistance per unit time ΔΩ [Ω/ms]. The solid line represents the rate of change in the resistance in the liquid under test. The dashed line represents the rate of change in the resistance in the liquid under test that is not contaminated by impurities (hereinafter referred to as the reference rate as appropriate). When conductive impurities are mixed in the liquid under test, the resistance of the liquid under test decreases when conductive impurities pass between the first electrode 114 and the second electrode 116. In this case, as shown in Fig. **6****,** the rate of change in the resistance changes abruptly. That is, the rate of change in the resistance of the liquid under test rises above the reference rate after dropping below the reference rate and then returns to the reference rate or a value in the neighborhood. When insulating impurities pass between the first electrode 114 and the second electrode 116, the resistance of the liquid under test increases, and the rate of change in the resistance changes rapidly in association with that, although an illustration thereof is omitted. That is, the rate of change in the resistance of the liquid under test drops below the reference rate after rising above the reference rate and then returns to the reference rate or a value in the neighborhood. For example, the rate of change in the resistance of the liquid under test can vary in a range 1Ω/ms to 200 Ω/ms between 1 ms and 10 ms when impurities pass between the pair of electrodes.

This variation in the rate of change in the resistance occurs whether the impurities are magnetic or non-magnetic. Therefore, the rate of change in the resistance of the liquid under test is an indicator for determining whether the liquid under test contains impurities. Therefore, it is possible to detect contamination by impurities by capturing a variation in the rate of change in the resistance of the liquid under test flowing in the pipe 102.

It is also possible to detect contamination by impurities by capturing a change in the resistance of the liquid under test. For example, as in embodiment **1, a** possible resistance of the reference liquid may be defined as a reference resistance, and it may be determined that impurities are mixed when the difference between the actual resistance of the liquid under test and the reference resistance exceeds a predetermined threshold. However, the temperature of the liquid under test, for example, can change due to a change in air temperature and the like. When the temperature of the liquid under test changes, the resistance of the liquid under test can also change. For example, the resistance of the liquid under test tends to decrease as the temperature increases.

Therefore, the temperature of the liquid under test rises gradually, and the resistance of the liquid under test decreases gradually in association with that when, for example, the resistance of the liquid under test is measured from morning to noon. Eventually, the difference from the reference resistance may exceed the threshold. For this reason, it may be determined in error that impurities have been mixed even if the liquid under test does not contain impurities if the resistance of the liquid under test itself is used as an indicator for determining the presence or absence of impurities.

On the other hand, it is possible to distinguish between a sudden resistance change that occurs when impurities pass between the pair of electrodes and a gradual resistance change due to a factor such as temperature change by capturing the rate of change in the resistance of the liquid under test. This makes it possible to detect impurities with higher accuracy. In addition, impurities can be detected without controlling the temperature of the liquid under test.

The determination unit 112 determines whether the liquid under test contains impurities according to the amount of change in the resistance per unit time calculated by the calculation unit 110. When the rate of change in the resistance varies beyond a predetermined threshold, for example, the determination unit 112 determines that the liquid under test contains impurities. The threshold value is preset and maintained in the storage unit 120. The threshold can be set appropriately based on an experiment, simulation, etc. by the designer. Since the impurity detection support device 100 includes the determination unit 112, the user can grasp contamination by impurities more quickly than otherwise.

As an example, the determination result of the determination unit 112 is sent to the control device 24. The control device 24 is the same as the control device 24 of embodiment 1 except that the rate of change in the resistance calculated by the calculation unit 110 can be transmitted, the value of this rate of change can be displayed on the monitor, and the user can determine the presence or absence of impurities from the value of the rate of change. Therefore, a description of the control device 24 will be omitted.

Since the execution and the change in the setting of the impurity detection process are the same as those of embodiment 1, a description thereof is omitted.

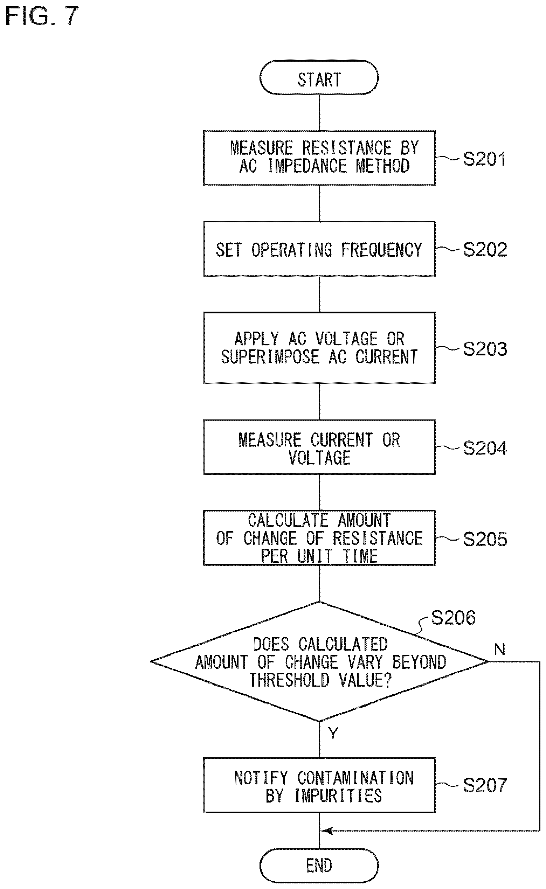

Fig. 7 is a flowchart showing an example of the impurity detection support method according to embodiment 2. This flow is repeatedly executed at, for example, a predetermined interval. First, the resistance of the liquid under test or the resistance of the reference liquid is measured by the AC impedance method (S201). Then, the operating frequency is determined based on the resistance measured in step S201 (S202).

Subsequently, while the liquid under test is flowing through the pipe 102, an AC voltage with a frequency fixed at the operating frequency is applied or an AC current with a frequency fixed at the operating frequency is superimposed between the first electrode 114 and the second electrode 116 (S203). As a result, an AC voltage is applied to or an AC current is superimposed on the liquid under test in the space expanding between the first position 102a and the second position 102b. Then, the current generated between the first electrode 114 and the second electrode 116 due to the application of the AC voltage, or the voltage generated between the first electrode 114 and the second electrode 116 due to the superposition of the AC current is measured (S204). Subsequently, the amount of change in the resistance of the liquid under test per unit time is calculated based on the measured current or voltage (S205). It is then determined whether the amount of change calculated varies beyond a threshold value (S206).

When the amount of change in the resistance per unit time varies beyond the threshold value (Y in S206), the user is notified that the liquid under test contains impurities (S207), and the routine ends. When the amount of change in the resistance per unit time does not vary or varies in a range not beyond the threshold value (N in S206), the user is not notified, and the routine ends.

As described above, the impurity detection support device 100 according to this embodiment measures the amount of change in the resistance per unit time that serves as an indicator for determining the presence or absence of impurities, by applying an AC voltage to or superimposing an AC current on the liquid under test. Therefore, a highly reliable determination indicator can be obtained even if the impurities are non-magnetic. Accordingly, the rate of detection of impurities in the liquid under test can be increased. In addition, it is possible to determine contamination by impurities by eliminating a change in the resistance of the liquid under test based on a factor other than impurities such as an environmental change. As a result, the rate of detection of impurities in the liquid under test can be increased, and the accuracy of detection of impurities can also be increased.

Further, the frequency of the AC voltage applied to or the AC current superimposed on the liquid under test is fixed at the operating frequency. For this reason, the time required for measurement of the rate of change in the resistance can be shortened. According to this embodiment, the rate of change in the resistance of the liquid under test can be measured on the order of, for example, several milliseconds. Further, since an electric field is generated in the liquid under test flowing in the pipe 102, impurities can be detected while the liquid under test is being transported. In other words, an in-line impurity detection process can be realized. In addition, complete inspection of the liquid under test can be easily realized since a work such as sample collection is not required. Therefore, it is possible to suppress introduction of foreign matter into the subsequent process.

By way of example, the liquid under test is an electrode slurry containing a solvent and at least one of an electrode active material or a conductive additive. In this case, it is possible to suppress a short circuit between the positive and negative electrodes caused by impurities themselves by detecting impurities with high accuracy. If the positive electrode slurry contains impurities (particularly, metal impurities) in a power storage device in which an electrolytic solution is interposed between the positive and negative electrodes, impurities could elute in the electrolytic solution when the power storage device is charged, resulting in reduction and precipitation on the surface of the negative electrode. When this precipitation is repeated, impurities could grow in a dendrite shape, penetrate the separator, and reach the positive electrode, causing a short circuit. Therefore, it is also possible to suppress a short circuit caused by a dendrite, by increasing the rate of detection of impurities.

As an example, the pipe 102 is provided in the coating device 1 including the coating die 2 for applying the liquid under test to the coated body 16 and the tank 6 for storing the liquid under test. Alternatively, the pipe 102 is provided in a circulation device or a transport device for the liquid under test. Thereby, the impurity detection process can be performed in the process of transporting the liquid under test from the tank 6 to the coating die **2.** Further, the impurity detection process can be applied to the liquid under test until just before the liquid under test is applied to the coated body 16, by arranging the impurity detection support device 100 in the feed pipe 10 or the die supply pipe 14 of the coating device **1.** Thereby, the risk of foreign matter contamination in the electronic device can be further reduced, and the performance of the electronic device can be further improved.

Further, the impurity detection support device 100 can be mounted in an existing device simply by using a part of the pipe in the existing device as the pipe 102, or by replacing a part of the pipe by the pipe 102 of the impurity detection support device 100. Therefore, the installation, replacement, and maintenance of the impurity detection support device 100 are easy.

A plurality of impurity detection support devices 100 may be arranged in parallel in the coating device 1, the circulation device, the transport device, and the like. For example, the feed pipe 10 may be composed of two pipes 102 connected in parallel to the tank 6 and the pump 8, and the impurity detection support device 100 may be provided for each pipe 102. This reduces the pressure loss of the flow of the liquid under test due to the installation of the impurity detection support device 100. Further, the number of impurity detection support devices 100 increases so that the processing speed of the liquid under test can be increased. Further, by changing a condition to calculate the rate of change in the resistance in each impurity detection support device 100, it is possible to grasp the resistance behavior of the liquid under test due to an environmental change and the like in more detail, thereby further improving the accuracy of impurity detection. The parallel arrangement of the plurality of impurity detection support devices 100 can also be applied to embodiment 1.

### (Embodiment 3)

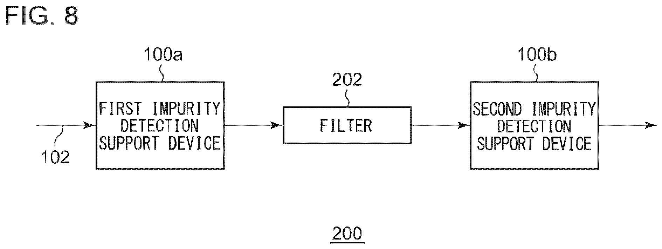

This embodiment is directed to a system 200 for processing the liquid under test including a plurality of impurity detection support devices 100 according to embodiment **2.** Fig. 8 is a schematic diagram of the system 200 for processing the liquid under test according to embodiment **3.**

The system 200 for processing the liquid under test under test according to this embodiment includes a first impurity detection support device 100a and a second impurity detection support device 100b. The first impurity detection support device 100a and the second impurity detection support device 100b each has the same configuration as the impurity detection support device 100 according to embodiment **2.** The first impurity detection support device 100a and the second impurity detection support device 100b may each have the same configuration as the impurity detection support device 100 according to embodiment **1.** The first impurity detection support device 100a and the second impurity detection support device 100b can calculate the rate of change in the resistance of the liquid under test independently of each other and can determine whether the liquid under test contains impurities. As an example, each device sends a calculation result or a determination result to the control device 24.

The first impurity detection support device 100a and the second impurity detection support device 100b are connected to each other by the pipe 102. Further, the first impurity detection support device 100a is disposed on the upstream side of the second impurity detection support device 100b in the pipe 102. As an example, the tank 6 is disposed on the upstream side of the first impurity detection support device 100a. On the downstream side of the second impurity detection support device 100b, a pump 8 is disposed as an example. That is, the system 200 for processing the liquid under test under test is incorporated into the coating device **1.** The configuration on the upstream side of the first impurity detection support device 100a and the downstream side of the second impurity detection support device 100b is not particularly limited. That is, the system 200 for processing the liquid under test may be incorporated into a device other than the coating device 1, such as a circulation device or a transport device for the test liquid.

A filter 122 is provided between the first impurity detection support device 100a and the second impurity detection support device 100b in the pipe 102. The filter 122 may be one that collects impurities that may be contained in the liquid under test, and a known filter medium such as a mesh or a nonwoven fabric can be employed. Further, the filter 122 may be a magnetic separator.

In this way, the rate of detection of and the accuracy of detection of impurities can be increased by disposing the first impurity detection support device 100a on the upstream side of the filter 122 and disposing the second impurity detection support device 100b on the downstream side of the filter 122 to determine the presence or absence of impurities in the liquid under test using each device. Further, it is possible to determine whether impurities are successfully trapped in the filter 122 or determine the amount of impurities trapped in the filter 122 by referring to the difference between the detection results of the first impurity detection support device 100a and the second impurity detection support device 100b. This makes it possible to grasp the timing for replacement of the filter 122 accurately. The system 200 for processing the liquid under test may include three or more impurity detection support devices 100 connected in series with each other and two or more filters 202.

### (Embodiment 4)

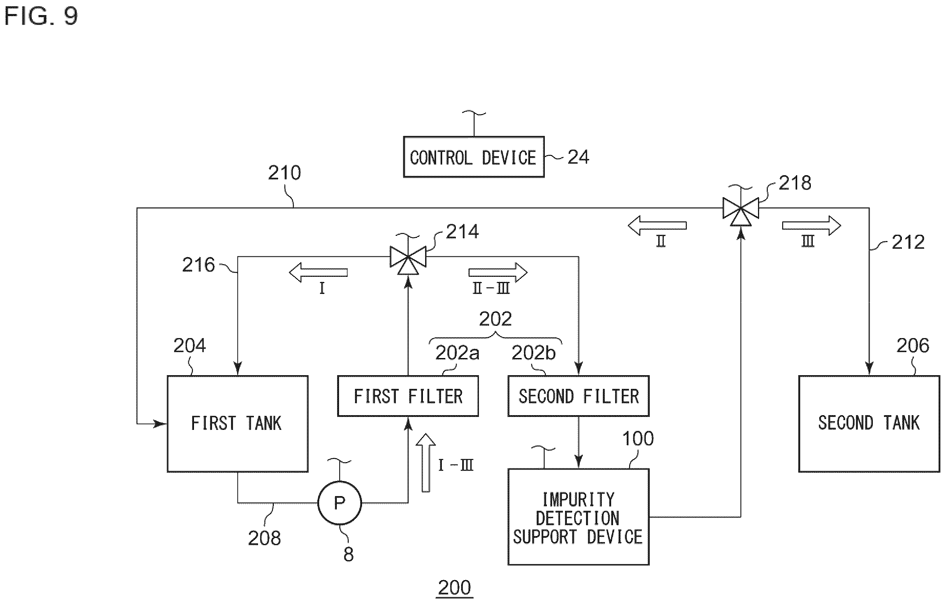

This embodiment is directed to a system 200 for processing the liquid under test including an impurity detection support device 100 according to embodiment **2.** Fig. 9 is a schematic diagram of the system 200 for processing the liquid under test according to embodiment **4.**

The system 200 for processing the liquid under test under test according to this embodiment includes an impurity detection support device 100, a first tank 204, a second tank 206, a first pipe 208, a second pipe 210, a third pipe 212, a filter 202, and a control device 24.

The impurity detection support device 100 has the same configuration as the impurity detection support device 100 according to embodiment **2.** The impurity detection support device 100 may include the same configuration as the impurity detection support device 100 according to embodiment **1.** The first tank 204 stores the liquid under test not determined to be free of impurities by the impurity detection support device 100. For example, the liquid under test is input into the first tank 204 from outside the system 200 for processing the liquid under test. The second tank 206 stores the liquid under test determined to be free of impurities by the impurity detection support device 100. One end of the first pipe 208 is connected to the first tank 204, and the other end is connected to the impurity detection support device 100. One end of the second pipe 210 is connected to the impurity detection support device 100, and the other end is connected to the first tank 204. One end of the third pipe 212 is connected to the impurity detection support device 100, and the other end is connected to the second tank 206.

The filter 202 is disposed in the first pipe 208. As in embodiment 3, the filter 122 may collect impurities that may be contained in the liquid under test, and a known filter medium such as a mesh or a nonwoven fabric, a magnetic separator, or the like can be employed. The system 200 for processing the liquid under test of this embodiment includes a first filter 202a and a second filter 202b as the filter 202. As an example, the first filter 202a is composed of a magnetic separator, and the second filter 202b is composed of a mesh. The first filter 202a is disposed upstream of the flow of the liquid under test with respect to the second filter 202b.

Further, the system 200 for processing the liquid under test of this embodiment includes a first switching valve 214 and a fourth pipe 216. The first switching valve 214 can be composed of a known valve such as an electromagnetic three-way valve. The first switching valve 214 is disposed between the first filter 202a and the second filter 202b in the first pipe 208. One end of the fourth pipe 216 is connected to the first switching valve 214, and the other end is connected to the first tank 204. The first switching valve 214 can switch between sending the liquid under test that has passed through the first filter 202a to the second filter 202b via the first pipe 208 or sending it to the first tank 204 via the fourth pipe 216.

Further, the system 200 for processing the liquid under test of this embodiment includes a second switching valve 218. The second switching valve 218 can be composed of a known valve such as an electromagnetic three-way valve. The second switching valve 218 is disposed in the middle of the second pipe 210 and the third pipe 212. In this embodiment, the second pipe 210 and the third pipe 212 are configured as a common pipe between the impurity detection support device 100 and the second switching valve 218. On the downstream side of the second switching valve 218, the second pipe 210 and the third pipe 212 are configured as pipes that are different from each other. The second switching valve 218 can switch between sending the liquid under test that has passed through the impurity detection support device 100 to the first tank 204 via the second pipe 210 or sending it to the second tank 206 via the third pipe 212.

Further, the system 200 for processing the liquid under test of this embodiment has the pump 8 in the middle of the first pipe 208. The pump 8 is driven to feed the liquid under test from the first tank 204 to each pipe.

The control device 24 has the same configuration as the control device 24 of embodiment 2. When the impurity detection support device 100 includes the same configuration as the impurity detection support device 100 according to embodiment 1, the control device 24 includes the same configuration as the control device 24 of the first embodiment. The control device 24 acquires a determination result from the impurity detection support device 100, controls the first switching valve 214 and the second switching valve 218 according to the determination result, and switches the flow path of the liquid under test. Further, the control device 24 controls how the pump 8 is driven.

As an example, the control device 24 can control the system 200 for processing the liquid under test to take a first state to a third state. In Fig. 9, the flow of the liquid under test in the first state is indicated by arrow I, the flow of the liquid under test in the second state is indicated by arrow II, and the flow of the liquid under test in the third state is indicated by arrow III.

In the first state, the first switching valve 214 is controlled so that the liquid under test that has passed through the first filter 202a returns to the first tank 204 via the fourth pipe 216. Then, the pump 8 is driven. Thereby, the liquid under test circulates between the first tank 204 and the first filter 202a. As a result, impurities in the liquid under test are collected by the first filter 202a.

Preliminary purification of the liquid under test can be performed by causing the system 200 for processing the liquid under test to take the first state. The control device 24 switches the system 200 for processing the liquid under test to the second state after the preliminary purification is completed. Completion of the preliminary purification can be determined based on a known determination indicator such as the time elapsed from the start of preliminary purification. As an example, the pump 8 may be kept being driven even when the state of the system 200 for processing the liquid under test is switched.

In the second state, the first switching valve 214 is controlled so that the liquid under test that has passed through the first filter 202a is guided to the second filter 202b via the first pipe 208. Further, the second switching valve 218 is controlled so that the liquid under test that has passed through the impurity detection support device 100 returns to the first tank 204 via the second pipe 210. This causes the liquid under test to pass from the first tank 204 through the first filter 202a and the second filter 202b and to flow to the impurity detection support device 100 via the first pipe 208. As a result, the presence or absence of impurities is determined by the impurity detection support device 100 after impurities in the liquid under test are collected by the first filter 202a and the second filter 202b. The liquid under test that has passed through the impurity detection support device 100 flows from the impurity detection support device 100 to the first tank 204 via the second pipe 210. Therefore, the liquid under test circulates between the first tank 204, the two filters, and the impurity detection support device 100.

The liquid under test subjected to preliminary purification can be subjected to main purification by the second filter 202b and then subjected to an impurity detection process by causing the system 200 for processing the liquid under test to take the second state. As an example, the impurity detection support device 100 determines that the liquid under test does not contain impurities when the rate of change in the resistance does not vary beyond the threshold value for a predetermined time (for example, from several seconds to several tens of seconds). This means that main purification by the second filter 202b has been completed.

When the control device 24 acquires a determination result indicating that the liquid under test does not contain impurities from the impurity detection support device 100, the control device 24 switches the system 200 for processing the liquid under test to the third state after a predetermined time has elapsed from the acquisition. The predetermined time is, for example, the time elapsed until the liquid under test present in the pipe from the impurity detection support device 100 to the second switching valve 218 passes through the second switching valve 218 completely. By waiting for a predetermined time from the acquisition of the determination result until the switching to the third state, it is possible to avoid the liquid under test that has passed through the impurity detection support device 100 before the liquid under test is determined to be free of impurities, i.e., the liquid under test that main purification has not been completed, from being sent to the second tank 206. The liquid under test that has not been completed main purification will be in a state of having been completed main purification by passing through the second filter 202b again after the system 200 for processing the liquid under test is switched to the third state.

In the third state, the first switching valve 214 is controlled so that the liquid under test that has passed through the first filter 202a is guided to the second filter 202b via the first pipe 208. Further, the second switching valve 218 is controlled so that the liquid under test that has passed through the impurity detection support device 100 is guided to the second tank 206 via the third pipe 212. This causes the liquid under test to pass from the first tank 204 to the impurity detection support device 100 via the first pipe 208 and to flow from the impurity detection support device 100 to the second tank 206 via the third pipe 212. As a result, the liquid under test determined to be free of impurities can be stored in the second tank 206.

Further, the control device 24 switches the system 200 for processing the liquid under test to the second state immediately when the control device 24 acquires a determination result indicating that the liquid under test contains impurities from the impurity detection support device 100 while the system 200 for processing the liquid under test is in the third state. That is, the control device 24 switches the flow path of the liquid under test between the second pipe 210 and the third pipe 212 according to the determination result of the impurity detection support device 100. This makes it possible to guarantee that the liquid under test stored in the second tank 206 does not contain impurities more reliably than otherwise. Further, as an example, the control device 24 switches the system 200 for processing the liquid under test to the first state and repeats the above-described flow when the liquid under test is newly input into the first tank 204.

The structure of the system 200 for processing the liquid under test including the arrangement of the pipes, the pump 8, the switching valves, and the like is not limited to that shown in Fig. 9 and can be modified as appropriate. Further, the impurity detection support device 100 may be further provided between the first filter 202a and the first switching valve 214, and the level of purification of the liquid under test by the first filter 202a may be monitored when the system 200 for processing the liquid under test is in the first state or the second state.

Further, the liquid under test in which impurities are detected may be caused to flow to a tank different from the first tank 204 or the second tank 206 and to a circulation pipeline connected to a filter different from the first filter 202a or the second filter 202b to purify the liquid under test in the circulation pipeline when the system 200 for processing the liquid under test is in the second state. The liquid under test purified in this circulation pipe is, for example, returned to the pipeline between the first switching valve 214 and the second filter 202b, and the presence or absence of impurities is determined again by the impurity detection support device 100. Then, the system 200 for processing the liquid under test is switched to the third state when it is determined by the impurity detection support device 100 that impurities are not contained. The liquid is returned to the circulation pipeline again when it is determined that impurities are contained. According to this purification method, the liquid under test purified by the filter 202 and the liquid under test remaining in the first tank 204 and not purified by the filter 202 can be handled separately. As a result, mixing of both liquids under test can be suppressed, and impurities in the liquid under test not purified yet are prevented from contaminating the liquid under test that has been purified. Therefore, the efficiency of the purification process can be improved.

Embodiments 2 to 4 of the present disclosure have been described above in detail. The embodiments described above are merely specific examples of practicing the present disclosure. The details of the embodiment shall not be construed as limiting the technical scope of the present disclosure. A number of design modifications such as modification, addition, deletion, etc. of constituting elements may be made to the extent that they do not depart from the idea of the present disclosure defined by the claims. New embodiments with design modifications will provide the combined advantages of the embodiment and the variation. Although the details subject to such design modification are emphasized in the embodiments by using phrases such as "of this embodiment" and "in this embodiment", details not referred to as such are also subject to design modification. Any combination of the above constituting elements is also useful as an embodiment of the present disclosure. Hatching in the cross section in the drawings should not be construed as limiting the material of the hatched object.

The invention according to embodiment 2 to 4 described above may be defined by the following items.

### [Item 7]

An impurity detection support device (100) including:
a pipe (102) in which a liquid under test flows;
a first electrode (114) and a second electrode (116) provided in the pipe (102), the first electrode (114) and the second electrode (116) being arranged such that an AC voltage is adapted to be applied to or an AC current is adapted to be superimposed on the liquid under test in a space extending between a first position (102a) of the pipe (102) and a second position (102b) shifted from the first position (102a) in a direction of extension of the pipe (102);
a power supply unit (106) that applies an AC voltage with a frequency fixed at a predetermined operating frequency or superimposes an AC current with a frequency fixed at the operating frequency between the first electrode (114) and the second electrode (116);
a measurement unit (108) that measures a current generated between the first electrode (114) and the second electrode (116) due to application of the AC voltage or measures a voltage generated between the first electrode (114) and the second electrode (116) due to superposition of the AC current; and
a calculation unit (110) that calculates an amount of change in a resistance of the liquid under test per unit time using a measurement result of the measurement unit (108), the amount of change per unit time being an indicator for determining whether the liquid under test contains impurities,
wherein the operating frequency is determined based on a resistance of the liquid under test or a resistance of a reference solution not containing impurities measured by AC impedance method.

### [Item 8]

The impurity detection support device (100) according to Item 7, including:
a determination unit (112) that determines whether the liquid under test contains impurities according to the amount of change calculated by the calculation unit (110).

### [Item 9]

The impurity detection support device (100) according to Item 7 or Item 8,
wherein the liquid under test is an electrode slurry containing a solvent and at least one of an electrode active material or a conductive additive.

### [Item 10]

The impurity detection support device (100) according to any one of Item 7 to Item 9, wherein
the pipe (102) is provided in at least one of a coating device (1) that coats a coated body (16) with the liquid under test, a circulation device for the liquid under test, or a transport device for the liquid under test.

### [Item 11]

A system (200) for processing a liquid under test including a plurality of the impurity detection support devices (100) according to any one of Item 1 to Item 4 and Item 7 to Item 10,
wherein the system (200) includes, as the impurity detection support devices (100), a first impurity detection support device (100a) and a second impurity detection support device (100b) connected to each other by a pipe (102) in which the liquid under test flows, and
wherein the system comprises a filter (202) provided between the first impurity detection support device (100a) and the second impurity detection support device (100b) in the pipe (102) to collect impurities in the liquid under test.

### [Item 12]

A system (200) for processing a liquid under test, including:
the impurity detection support device (100) according to any one of Item 2 to Item 4 and Item 8 to Item 10;
a first tank (204) that stores the liquid under test not determined to be free of impurities by the impurity detection support device (100);
a second tank (206) that stores the liquid under test determined to be free of impurities by the impurity detection support device (100);
a first pipe (208) connected to the first tank (204) and the impurity detection support device (100), in which first pipe (208) the liquid under test guided from the first tank (204) to the impurity detection support device (100) flows;
a second pipe (210) connected to the impurity detection support device (100) and the first tank (204), in which second pipe (210) the liquid under test guided from the impurity detection support device (100) to the first tank (204) flows;
a third pipe (212) connected to the impurity detection support device (100) and the second tank (206), in which third pipe (212) the liquid under test guided from the impurity detection support device (100) to the second tank (206) flows;
a filter (202a, 202b) provided in the first pipe (208) to collect impurities in the liquid under test; and
a control device (24) that switches a flow path of the liquid under test between the second pipe (210) and the third pipe (212) according to a determination result of the impurity detection support device (100).

### [Item 13]

An impurity detection support method including:
measuring a resistance of a liquid under test or a resistance of a reference solution not containing impurities by AC impedance method to determine a predetermined operating frequency based on the resistance measured;
causing the liquid under test to flow in a pipe (102);
applying an AC voltage with a frequency fixed at the operating frequency to or superimposing an AC current with a frequency fixed at the operating frequency on the liquid under test in a space extending between a first position (102a) of the pipe (102) and a second position (102b) shifted from the first position (102a) in a direction of extension of the pipe (102);
measuring a current generated due to application of the AC voltage or measuring a voltage generated due to superposition of the AC current; and
calculating an amount of change in a resistance of the liquid under test per unit time using a measurement result, the amount of change per unit time being an indicator for determining whether the liquid under test contains impurities.

### [Item 14]

The impurity detection support method according to Item 13, further including:
determining whether the liquid under test contains impurities according to the amount of change calculated.

### INDUSTRIAL APPLICABILITY

The present disclosure can be used in an impurity detection support device, an impurity detection support method, and a system for processing a liquid under test.

### REFERENCE SIGNS LIST

1 coating device, 24 control device, 100 impurity detection support device, 100a first impurity detection support device, 100b second impurity detection support device, 102 pipe, 102a first position, 102b second position, 106 power supply unit, 108 measurement unit, 110 calculation unit, 112 determination unit, 114 first electrode, 116 second electrode, 120 storage unit, 200 system for processing liquid under test, 202 filter, 204 first tank, 206 second tank, 208 first pipe, 210 second pipe, 212 third pipe

## Claims

1. An impurity detection support device comprising:
a pipe in which a liquid under test flows;
a first electrode and a second electrode provided in the pipe, the first electrode and the second electrode being arranged such that an AC voltage is adapted to be applied to or an AC current is adapted to be superimposed on the liquid under test in a space extending between a first position of the pipe and a second position shifted from the first position in a direction of extension of the pipe;
a power supply unit that applies an AC voltage with a frequency fixed at a predetermined operating frequency or superimposes an AC current with a frequency fixed at the operating frequency between the first electrode and the second electrode;
a measurement unit that measures a current generated between the first electrode and the second electrode due to application of the AC voltage or measures a voltage generated between the first electrode and the second electrode due to superposition of the AC current; and
a calculation unit that calculates a resistance of the liquid under test using a measurement result of the measurement unit, the resistance being an indicator for determining whether the liquid under test contains impurities,
wherein the operating frequency is determined based on a resistance of the liquid under test or a resistance of a reference solution not containing impurities measured by AC impedance method.

2. The impurity detection support device according to Claim 1, comprising:
a determination unit that determines whether the liquid under test contains impurities according to the resistance calculated by the calculation unit.

3. The impurity detection support device according to Claim 1 or 2,
wherein the liquid under test is an electrode slurry containing a solvent and at least one of an electrode active material or a conductive additive.

4. The impurity detection support device according to Claim 1 or 2,
wherein the pipe is provided in at least one of a coating device that coats a coated body with the liquid under test, a circulation device for the liquid under test, or a transport device for the liquid under test.

5. An impurity detection support method comprising:
measuring a resistance of a liquid under test or a resistance of a reference solution not containing impurities by AC impedance method to determine an operating frequency;
causing the liquid under test to flow in a pipe;
applying an AC voltage with a frequency fixed at the operating frequency to or superimposing an AC current with a frequency fixed at the operating frequency on the liquid under test in a space extending between a first position of the pipe and a second position shifted from the first position in a direction of extension of the pipe;
measuring a current generated due to application of the AC voltage or measuring a voltage generated due to superposition of the AC current; and
calculating a resistance of the liquid under test using a measurement result, the resistance being an indicator for determining whether the liquid under test contains impurities.

6. The impurity detection support method according to Claim 5, further comprising:
determining whether the liquid under test contains impurities according to the resistance calculated.

7. An impurity detection support device comprising:
a pipe in which a liquid under test flows;
a first electrode and a second electrode provided in the pipe, the first electrode and the second electrode being arranged such that an AC voltage is adapted to be applied to or an AC current is adapted to be superimposed on the liquid under test in a space extending between a first position of the pipe and a second position shifted from the first position in a direction of extension of the pipe;
a power supply unit that applies an AC voltage with a frequency fixed at a predetermined operating frequency or superimposes an AC current with a frequency fixed at the operating frequency between the first electrode and the second electrode;
a measurement unit that measures a current generated between the first electrode and the second electrode due to application of the AC voltage or measures a voltage generated between the first electrode and the second electrode due to superposition of the AC current; and
a calculation unit that calculates an amount of change in a resistance of the liquid under test per unit time using a measurement result of the measurement unit, the amount of change per unit time being an indicator for determining whether the liquid under test contains impurities,
wherein the operating frequency is determined based on a resistance of the liquid under test or a resistance of a reference solution not containing impurities measured by AC impedance method.

8. The impurity detection support device according to claim 7, comprising:
a determination unit that determines whether the liquid under test contains impurities according to the amount of change calculated by the calculation unit.

9. The impurity detection support device according to claim 7 or 8,
wherein the liquid under test is an electrode slurry containing a solvent and at least one of an electrode active material or a conductive additive.

10. The impurity detection support device according to Claim 7 or 8, wherein
the pipe is provided in at least one of a coating device that coats a coated body with the liquid under test, a circulation device for the liquid under test, or a transport device for the liquid under test.

11. A system for processing a liquid under test including a plurality of the impurity detection support devices according to Claim 1 or 7,
wherein the system comprises, as the impurity detection support devices, a first impurity detection support device and a second impurity detection support device connected to each other by a pipe in which the liquid under test flows, and
wherein the system comprises a filter provided between the first impurity detection support device and the second impurity detection support device in the pipe to collect impurities in the liquid under test.

12. A system for processing a liquid under test, comprising:
the impurity detection support device according to Claim 2 or 8;
a first tank that stores the liquid under test not determined to be free of impurities by the impurity detection support device;
a second tank that stores the liquid under test determined to be free of impurities by the impurity detection support device;
a first pipe connected to the first tank and the impurity detection support device, in which first pipe the liquid under test guided from the first tank to the impurity detection support device flows;
a second pipe connected to the impurity detection support device and the first tank, in which second pipe the liquid under test guided from the impurity detection support device to the first tank flows;
a third pipe connected to the impurity detection support device and the second tank, in which third pipe the liquid under test guided from the impurity detection support device to the second tank flows;
a filter provided in the first pipe to collect impurities in the liquid under test; and
a control device that switches a flow path of the liquid under test between the second pipe and the third pipe according to a determination result of the impurity detection support device.

13. An impurity detection support method comprising:
measuring a resistance of a liquid under test or a resistance of a reference solution not containing impurities by AC impedance method to determine a predetermined operating frequency based on the resistance measured;
causing the liquid under test to flow in a pipe;
applying an AC voltage with a frequency fixed at the operating frequency to or superimposing an AC current with a frequency fixed at the operating frequency on the liquid under test in a space extending between a first position of the pipe and a second position shifted from the first position in a direction of extension of the pipe;
measuring a current generated due to application of the AC voltage or measuring a voltage generated due to superposition of the AC current; and
calculating an amount of change in a resistance of the liquid under test per unit time using a measurement result, the amount of change per unit time being an indicator for determining whether the liquid under test contains impurities.

14. The impurity detection support method according to claim 13, further comprising:
determining whether the liquid under test contains impurities according to the amount of change calculated.
